Europäisches Patentamt

European Patent Office

Office européen des brevets

(11) Publication number: 0 453 753 A2

# EUROPEAN PATENT APPLICATION

(21) Application number: 91103988.1

(51) Int. Cl.5: G03F 7/20, G03F 1/14

(22) Date of filing: 15.03.91

(30) Priority: 18.04.90 US 510906

(43) Date of publication of application:
30.10.91 Bulletin 91/44

(84) Designated Contracting States:
BE CH DE DK ES FR GB IT LI NL SE

(71) Applicant: International Business Machines
Corporation
Old Orchard Road
Armonk, N.Y. 10504(US)

(72) Inventor: Hakey, Mark C.
P.O. Box 212
Milton, Vermont 05468(US)
Inventor: Horak, David V.
47 Briar Lane
Essex Junction, Vermont 05452(US)
Inventor: Rath, Peter C.
RD1 French Hill Road
St. Albas, Vermont 05478(US)

(74) Representative: Gaugel, Heinz, Dipl.-Ing.
IBM Deutschland GmbH Schönaicher
Strasse 220
W-7030 Böblingen(DE)

(54) Method and apparatus for enhancing the depth of focus in projection lithography.

(57) The invention provides a technique which enables projection lithography to extend to the sub-half micron range by compensating the Depth of Focus (DOF) budget lost in substrate topography with a projection of a non-planar image which is conformal to the substrate (10). The method of achieving a non-planar image field includes the formation of a mask reticle (20) which is a replica of the surface of the semiconductor (10) to be exposed, thus, eliminating substrate topography from the optical DOF budget.

Fig. 4.

EP 0 453 753 A2

This invention relates to projection lithography and particularly to the problems of forming submicron dimensional patterns for the manufacture of semiconductor devices using optical image exposure systems.

The field of optical lithography has experienced many advances in its capability to render smaller and smaller image sizes for a period in excess of twenty-five years. Historically, these advances have been instrumental in the development of semiconductor technology. In the recent past, semiconductor device structures requiring dimensions on the order one micron or less have been successfully fabricated using optical wavelength exposure sources. As the submicron region has been approached, the limits of optical lithography have been extended by reducing the wavelength of light to the point where light in the wavelength of a few hundred nanometers is required for adequate resolution.

Although other sources of exposing radiation, such as E-beam and X-ray, are capable of providing required submicron dimensions, they do so at considerable expense, both in capital and time. For example, E-beam direct write systems, extensively used in making masks for semiconductor fabrication, are generally unacceptable for routine manufacturing due to the slow rate at which complex images can be generated. X-ray technology, on the other hand does not have the time related limitations of E-beam technology but requires extremely expensive equipment to generate the soft X-ray radiation required for semiconductor fabrication.

Accordingly, over the last few years many advances have been made in the field of optical lithography to maintain its competitive status.

One of the most critical problems dealt with in any lithographic system is the problem of maintaining the object to be exposed within the Depth of Focus (DOF) of the optical exposure tool. In order to effectively utilize photolithography, it is necessary that the image created by the projection system be capable of exposing photosensitive layers on the entire surface of a wafer which can be larger that 200 mm in diameter. Many factors effect the ability of an imaging system to provide a properly focused image. The concept Depth of Focus is well known to photolithographers and refers to that region of an optical image in which the focus or intensity is maximized, i.e. focal plane. Since the light intensity distribution of the areal image is a gaussian distribution, the intensity falls off rather sharply on each side of the focal plane.

The Depth of Focus for an optical tool can be defined as

$$DOF = +/- (k \, (wavelength)/(NA)^2)$$

where k is a constant of about 0.7 and NA is the Numerical Aperture of the optical system, thus clearly tying DOF to the system parameters.

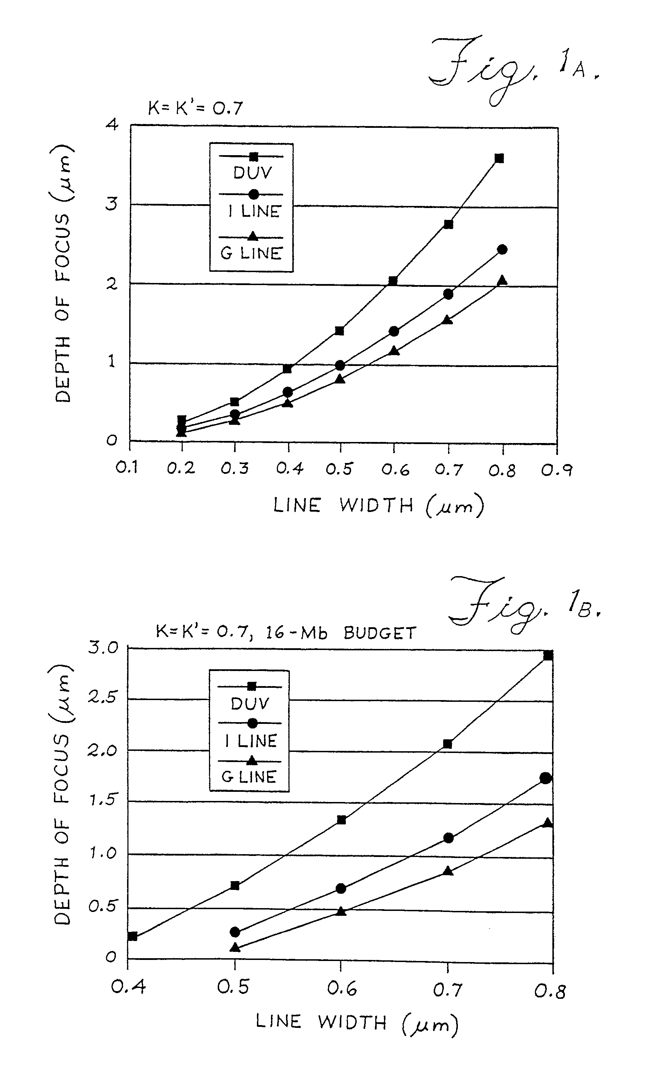

Fig. 1A illustrates DOF as a function of achievable resolution (Line Width) for three different frequencies of optical radiation, deep ultra-violet (DUV), I Line and G Line, based on a Rayleigh diffraction-limited model for resolution. As can be seen, the DOF decreases exponentially with increasing resolution. While resolution on the order of 0.2 microns is possible, restrictions on the useful DOF, or DOF 'budget' are quite severe in the submicron region. Fig. 1B is a similar representation as Fig. 1A, but includes the available DOF budget for a theoretical 16 Mb DRAM technology including the effects of resist thickness, topography, focus leveling and reticle planarity. Here the the available DOF is reduced to the submicron range for all of the optical wavelengths at any resolution less than 0.5 micron.

It is quite obvious from Figs. 1A and 1B that decreases in wavelength can be used to obtain greater resolution. In addition to the obvious techniques for increasing the effective DOF budget, such as directly altering the wavelength or NA, there have been proposed a number of techniques for improving or tightening the tolerances in other parameters of the DOF budget such as improved chip leveling for step and repeat tools, improved accuracy in focusing and improved control in the wavelength of exposure sources.

The specific parameters influencing DOF budget are described by B. Lin, in a paper presented at the Society of Photo-Optical Instrumentation Engineers Santa Clara Symposium on Microlithography, Santa Clara, California, February 28 - March 4, 1988. Dr. Lin points out the technological areas in which problems would be required to be overcome if the near theoretical limit of 0.18 micron resolution for optical lithography were to be reached. He described a model of a DOF budget in which the following technological features contribute:

topography of the exposed surface,

thickness of the photoresist,

flatness of the optical image,

flatness of the mask containing the patterns to be exposed,

ability to obtain accurate focus, and

the degree to which the exposed surface is tilted with respect to the projected image.

Of all of the factors, the current largest detractor is that of wafer topography, currently about 0.8 microns of the total DOF budget of 2.87 microns. Ultimate reduction in wafer topography to no more than 0.15 microns was projected to be required in order to achieve maximum resolution of 0.17 microns.

The article, "A Half Micron Technology for an Experimental 16 Mbit DRAM using i-Line Stepper," Y. Kawamoto et al, 1988 Symposium on VLSI Technology, May 10-13, 1988, describes a DOF budget reduction technique in which the surface of a semiconductor chip is rendered more planar by physically recessing certain regions on the surface of the substrate in order to reduce the extent of the vertical topography within exposure fields.

Another technique proposed which could reduce or eliminate some of the factors present in the DOF budget is described in the article "Submicrometer Holographic Photolithography," J. Brook et al. Solid State Technology, November 1989, pp. 91-94. A holographic system is used to generate the image plane on the surface of semiconductor wafers which is a duplicate image of that of the mask or object plane.

U.S. Patent 4,869,999 to Fukuda et al also relates to techniques for compensating for limited DOF budget. Here the optical energy in the real image is utilized in at least two independent axially displaced exposures of the same object or mask pattern in order to provide adequate exposure for all regions of the photosensitive wafer surface. A number of techniques are described for providing the axial displacement of the multiple images including:
moving the object parallel to the optical axis,
moving the mask parallel to the optical axis,
adding optical material to the optical path for one of the exposures,
changing the operating pressure of the exposure system,
using a lens having multiple focal points,
using multiple overlapping light beams, and
using a separate wavelengths for each exposure.

For all of the options, at least two exposures are required to form the desired image.

Each of the prior art techniques for extending the capabilities of optical lithography has a unique set of limitations. For example, requiring the semiconductor wafer to experience additional processing steps increases the cost of each item so processed. In a similar manner the addition of exposure steps also increases the cost of the product.

Accordingly, it is an object of this invention to provide a photolithographic image exposure system and method which is substantially independent of image plane topography.

It is another object of the invention to provide increased resolution of semiconductor device structures using optical light sources in the range of 0.18 to 0.25 microns.

It is a further object to provide for enhanced optical lithography without excessive increase in cost to manufacture.

The objects of the invention are accomplished by providing a focused image plane on the surface of a substrate which is substantially conformal to the topology of the substrate. The technique used to accomplish this includes a method of fabricating a mask reticle in which the surface of the reticle is a three-dimensional replica of the surface of the object to be exposed. As described herein, a method is taught for transferring the topology of a substrate to be exposed to the surface of the mask to be projected on the substrate.

These and other features of the invention will be more apparent to those skilled in the art from the more particular description of the invention, as illustrated in the accompanying drawings.

Ways of carrying out the invention are described in detail below with reference to drawings showing only specific embodiments in which:

Figs. 1A and 1B
are graphical representations illustrating the relationship between Depth of Focus, resolution and exposure wavelength based on a Rayleigh diffraction-limited model of an optical system. Fig. 1A represents the limits as dictated by optics alone and Fig. 1B represents the effective limits when the total optical environment is considered for a typical 16Mb DRAM technology.

Figs. 2A-2D
are representative cross-sectional views of a semiconductor substrate illustrating the results of processing steps prior an exposure in an optical exposure tool.

Figs. 3A-3G
are representative cross-sectional views of a optical mask or reticle of the invention illustrating the steps of preparing it for use in an optical exposure tool.

Fig. 4
is a schematic representation generally illustrating the relationship between elements in the reticle and in the semiconductor substrate when practicing the invention in a all-reflective or catadioptric optical system.

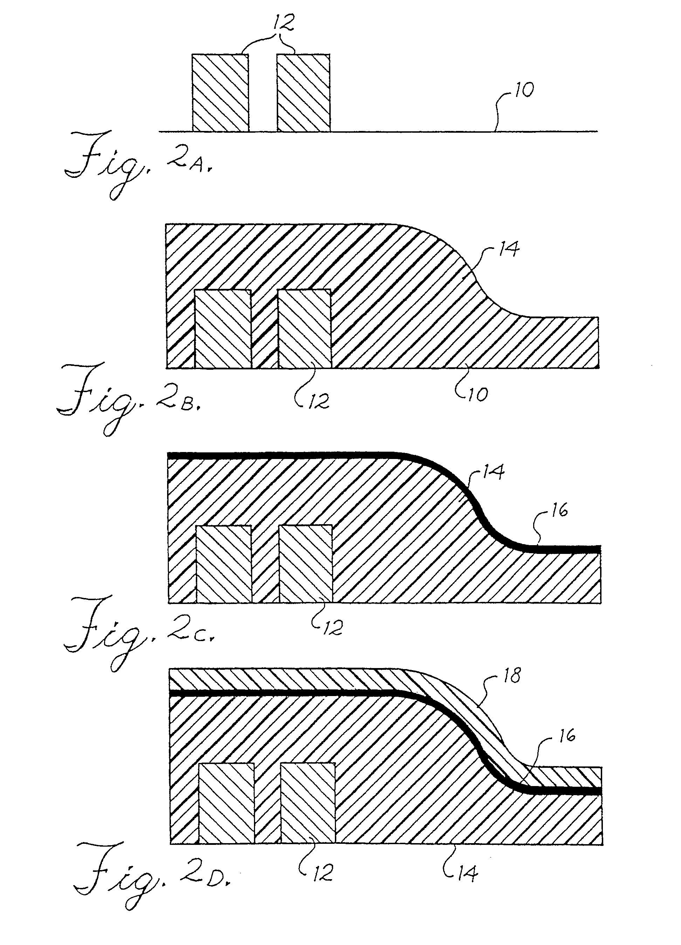

Referring now to Figs. 2A through 2D, there is described the photolithographical environment to which the invention applies. In Fig. 2A the surface 10 of a semiconductor wafer is show schematically. For purposes of discussion, surface 10 is illustrated as being planar, although in reality such surfaces are planar only with respect to the smallest of localized areas. Formed on the surface 10 are a plurality of technological elements 12, such as conductive lines, defined by a photolithographic process. The physical dimensions of lines 12 and/or the spaces between them can be in the submicron range. However, as shown the vertical dimensions may well be many times greater than the horizontal dimensions.

In preparation for a subsequent photoprocessing operation, a photolithographic process using a commonly designated Multi-Layer Resist (MLR) is applied over the structure of Fig. 1A. The process includes the application of a relatively conformal layer 14 of an organic material, as shown in Fig. 1B. Due the various parameters of the material, layer 14 will experience excursions in its vertical dimension of approximately the same extent as the thickness of the objects, lines 12, it is covering. Next, as shown in Fig. 1C, a relatively thin etch stop layer 16 is applied over layer 14. The required characteristics of layer 16 are that it can be easily defined by etching such that a pattern formed in layer 16 can be accurately transferred through underlying layer 14 by an anisotropic etching process. Finally, as shown in Fig. 1D, a thin photosensitive layer 18 is formed over layer 16. In the manufacture of semiconductor devices it is presumed that the imaging layer 18 can indeed be patterned for subsequent processing steps.

Referring to Fig. 1D, although not drawn with consistent vertical and horizontal scale, it can easily be seen that an imaging system suitable for simultaneously all of the surfaces of layer 18, must have the ability to provide enough light energy to adequately expose photosensitive material on all surfaces. Should the Depth of Focus (DOF) of the exposure tool be greater than the difference in height between the surfaces of layer 18, the layer can be exposed and processed successfully. However, as is more likely the case, there is a relationship between the desirable dimensions of the structures on a semiconductor surface and the DOF available. In submicron technologies where the horizontal resolution may be on the order of 0.5 micron, the DOF may inadequate to expose the entire photoresponsive surface in a field of view. Reduction in exposing wavelength, although useful in reducing minimum resolution, also severely reduces the DOF.

For a more detailed description of the various aspects of DOF budget parameters, see the above cited Lin paper, herein incorporated by reference.

Although the photolithographic aspects of Figs. 2A-2D are shown using a three-layer MLR, it will be understood that two-layer systems using 'top layer imaging' technology are also anticipated for use. For a detailed description of such resist systems sensitive to the DUV spectrum, see the following articles: "A 2-layer resist system derived from trimethylsilylstyrene," by S.A. MacDonald et al., Proceedings of SPIE, Vol. 631, pp. 28-33 (1986) and "Polysiloxanes for Optical Lithography," by J. Shaw et al., Solid State Technology, June 1987, pp. 83-89, both herein incorporated by reference.

In accordance with our invention, the problem of limited DOF is substantially diminished by causing the image plane to be conformably projected onto the surface of the photosensitive layer. As such, the DOF of the optical tool no longer remains a serious factor within the DOF budget, as described by Lin, above. The conventional limitation that the optical DOF exceed the maximum vertical height of structures on the surface of a wafer is eliminated.

Although the photolithographic tool makers have more or less successfully attempted for decades to provide the utmost in control over surface flatness and to provide optical elements having a minimum of planar distortion, such objectives become somewhat foreshadowed in view of the instant invention.

According to the invention, the optimum technique for producing a conformal image plane is to form a replica of the surface of the semiconductor within the mask or reticle containing the patterns for the next exposure process. Thus, effectively incorporating the historical 3-dimensional processing history of the wafer into the mask design will enable an image/focus plane to be formed which will exactly match the surface of the plane to be exposed.

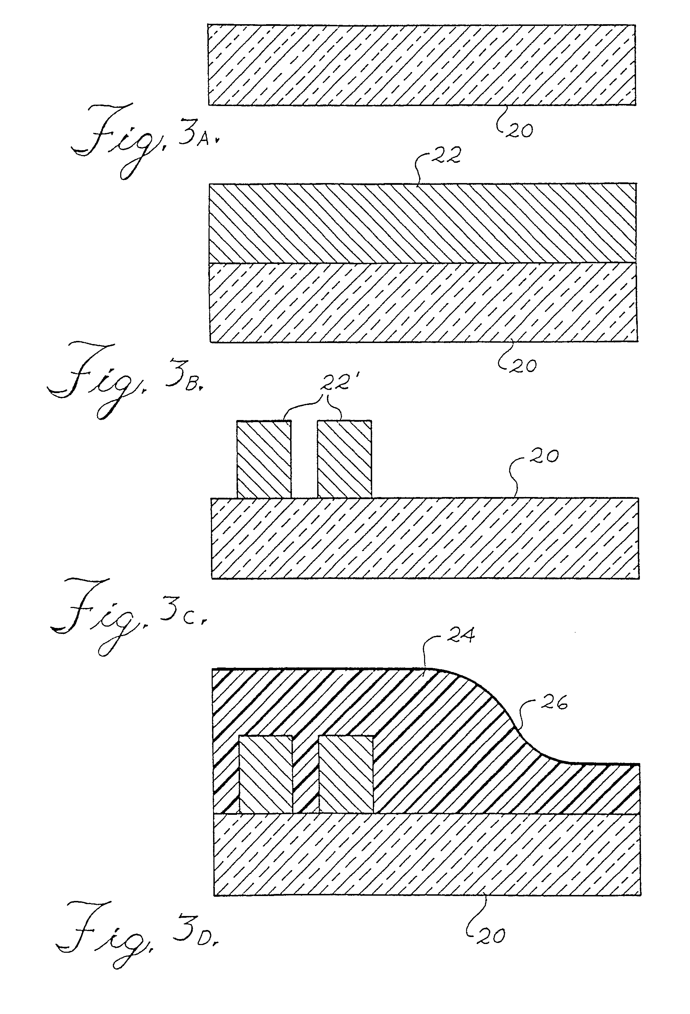

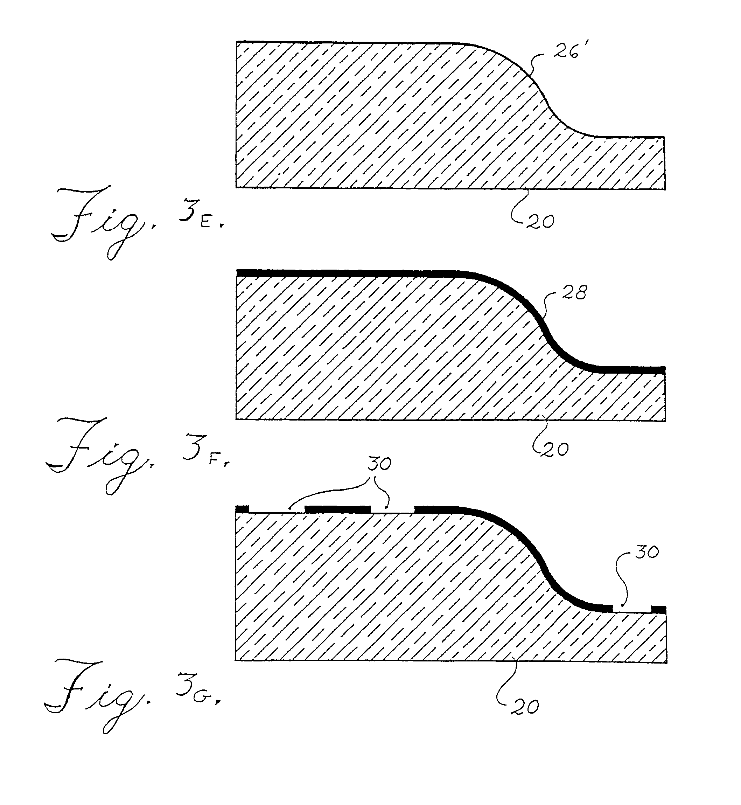

Referring now to Figs. 3A through 3G, there is shown the general sequence of steps necessary to provide a mask reticle according to the invention. Fig. 3A illustrates the initial reticle blank 20 formed on a material transparent to the radiation to be used in the optical system, preferably quartz. As shown in Fig. 3B, a layer 22 of a definable material such as an organic polymer or photoresist is spun on the surface of reticle blank 20. In the example shown, the single layer 20 is formed to the same thickness as the relief structure represented by lines 12 of Fig. 1. In order to provide a surface topography on the reticle blank the same as that on the wafer to be exposed, the layer 22 is photolithographicly defined, preferably by using an e-beam exposure tool, developing by a suitable process to leave an identical pattern 22' on the surface of the reticle blank as is on the surface of the wafer to be exposed. Should the semiconductor wafer have experienced additional processing steps, it will be understood analogous processing steps would be performed on the surface of the reticle blank 20. Then, as shown in Fig. 3D a layer 24 of organic material is spun on the reticle in order to provide a topographically identical nonplanar surface 26, substantially identical to that of the wafer to be processed. This material used for layer 24 should have the same physical characteristics as that of layer 14 of Fig. 2. Next, layers 22 and 24 are anisotropically etched in a Reaction Ion Etching (RIE) environment such that the etch ratio between organic and reticle blank material is N:1 where N is the refractive index of the reticle blank 20. This dependency of etch rate is required since in the preferred embodiment, the reticle material becomes part of the optical path in the preferred optical system, described below. The etching will enable the topography of surface 26 to be duplicated in the reticle 20. Etching is continued until all of the organic layers are removed from the reticle, leaving the image of plane 26 (Fig. 3D) in the surface of the reticle blank 20 as shown in Fig. 3E at 26'.

The process of making the mask reticle then continues in a manner identical to that of a conventional reflective mask. As shown in Fig. 3F, a blanket layer 28 of reflective mask segment forming material such as chromium is deposited on the surface of the reticle. A photosensitive layer (not shown) is applied and then a pattern is formed on the surface cf the reticle preferably using an e-beam system to define the segments of the mask, for example via holes 30 can be formed in layer 28, as shown in Fig. 3G. With the exception of a noncritical alignment step to insure that the relief pattern 26' formed in reticle blank is in proper alignment with the mask segment patterns.

As can be seen, different portions of the mask segments are associated with different portions of the substrate on to which the respective images are to be formed. The objective of the process is to produce a mask element in which the object plane is similar and preferably congruent with the surface of the workpiece onto which it will be projected. Thus, the optical path from each point on the surface of the mask to the corresponding point on the surface of the semiconductor wafer surface is maintained constant over the entire image field regardless of the topography of the wafer. Thus, the focal plane of the projected image, is no longer flat, but becomes a replica to the surface onto which it falls. The DOF budget due to wafer topography is effectively eliminated.

An important aspect of the invention lies in the reproducibility of the hydrodynamic properties of the organic layers used to form the surfaces layers 14 (Fig. 2D) and 26 (Fig. 3D).

As previously indicated, the preferred imaging system for application of the invention is that of the half-Wynne-Dyson projection system such as described in US Patent 3,171,871 issued October 23, 1979 to F.H. Dill et al and assigned to the assignee of the instant invention. A further detailed description of suitable optical systems is found in the article "Advances in 1:1 optical lithography," A.C. Stephanakis et al. Proceedings of SPIE, Vol.811, pp. 137-148 (1987). Both references hereby are incorporated by reference.

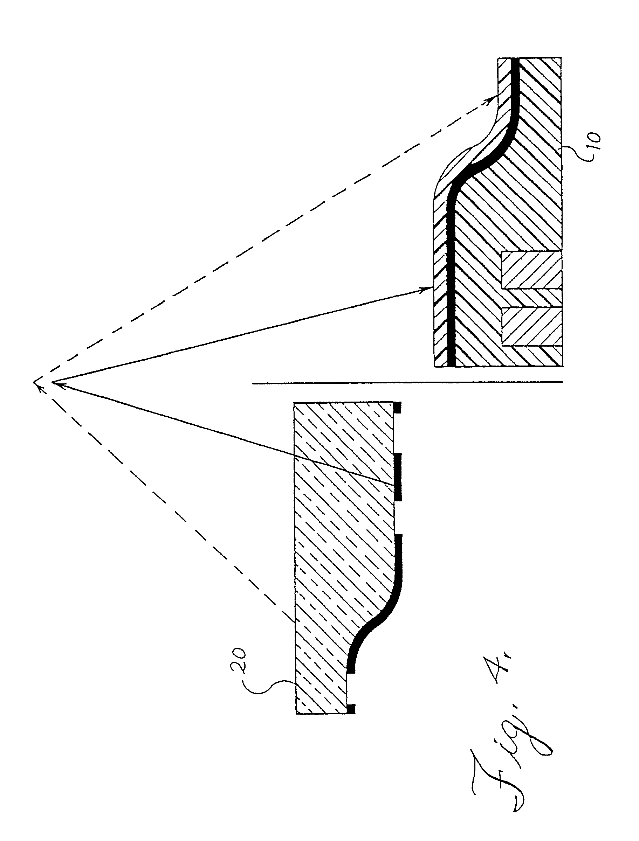

Fig. 4 is a schematic representation showing the arrangement of the semiconductor wafer 10 (from Fig. 2D) with respect to the mask reticle 20 (from Fig. 3G). Because the preferred optical system causes the mask image to be inverted, the entire reticle blank is flipped over when placed in the exposure tool. As shown in Fig. 4, the mask is placed on one-half of the optical input field and its inverted image is projected on the other half of the field. The respective dashed and solid arrows represent two different optical paths each having the same effective length.

As will be recognized, the exposure system of this invention may not be required at all processing steps in the manufacture of semiconductor devices, and may, in fact, provide critical leverage for the use of optical lithography throughout a process when utilized at a single process step. Whether utilized for single or multiple exposure steps, the profile of the mask reticle blank required will effectively include a topographical history of the steps which precede the step in which the invention is used.

Although the invention has been described in terms of a preferred embodiment, those skilled in the art will understand that other embodiments and variations may be carried out with out detracting from the spirit of the invention. For example, although the preferred embodiment is described in terms of a 1X optical system, other systems such as 5X reduction systems can be adapted to use the invention, keeping in mind the 5:1 vertical to linear differential dimensions present in such a system. The preferred embodiment includes a full field step and repeat arrangement which could be replaced by various forms of sub-field scanning or even a full wafer field. Since the optical characteristics of other wavelengths, both longer or shorter that those of the traditional optical spectra, behave similarly to those preferred, it will be recognized that the could equally be utilized regardless of wavelength used.

## Claims

1. An image exposure system for projecting a focused image on the surface of a non-planar substrate (10) comprising

   a projection tool have a predetermined depth of focus, being a function of exposing radiation and Numerical Aperture;

   a substrate (10) have an exposure surface including an exposure field including at least two regions (12) having a difference in elevation greater than the depth of field of said tool;

   object image generating means including a plurality of image segments defining a field to be projected, and

means for causing a single focused image to be formed within the exposure field on the non-planar surface of said substrate (10) corresponding to the plurality of image segments.

2. The system of claim 1 wherein the object image generating means comprises a mask reticle (20) having at least one of said plurality of image segments formed on a different plane from the remainder of said image segments.

3. The system of claim 2 wherein the mask reticle (20) includes a non-planar surface (26) which is substantially similar to the surface of the substrate (10).

4. The system of claim 2 or 3 wherein the surface (26) of the mask reticle is substantially a replica of the surface of the substrate (10).

5. The system of claim 1 wherein the image plane formed on the non-planar substrate (10) is substantially conformal with the surface of the substrate (10).

6. The system of one or more of the preceding claims 1 to 5 wherein the exposing radiation is in the range of optical spectra.

7. A method of exposing a composite image on the surface of a non-planar substrate (10) within a single exposure field wherein the substrate (10) includes a plurality of regions (12) of differing height, comprising the steps of:

generating a first portion of the image to be exposed from a first plurality of object segments corresponding to a first group of image segments to be projected on to a first of the regions of the substrate (10); and

independently generating a second portion of the image to be exposed from a second plurality of object segments corresponding to a second group of image segments to be projected on to a second of the regions of the substrate (10).

8. The method of claim 7 wherein the steps of generating portions of the images include the use of a mask reticle (20) having at least one non-planar surface (26) within the single exposure field.

9. The method of claim 8 wherein the surface of the mask reticle (20) is a replica of the surface (10) of the substrate.

10. A method of exposing a semiconductor surface (10) in a series of exposure steps wherein at least one of the masks (20) used to expose at least one of the series of exposure steps is fabricated to include a topographical history of the processing steps which precedes its use.

11. The method of claim 10 wherein said at least one mask (20) is formed through the use of pattern information present in at least one of its preceding process steps.

*Fig. 1A.*

K= K'= 0.7

*Fig. 1B.*

K=K'= 0.7, 16-Mb BUDGET

Fig. 2A.

Fig. 2B.

Fig. 2C.

Fig. 2D.

Fig. 3A.

Fig. 3B.

Fig. 3C.

Fig. 3D.

Fig. 3E.

Fig. 3F.

Fig. 3G.

Fig. 4.